Europäisches Patentamt

European Patent Office

Office européen des brevets

(11) Publication number: **0 327 916**
**A2**

## EUROPEAN PATENT APPLICATION

(21) Application number: **89101546.3**

(22) Date of filing: **30.01.89**

(51) Int. Cl.⁴: **H05K 13/02**

(30) Priority: **10.02.88 IT 1936288**

(43) Date of publication of application:
**16.08.89 Bulletin 89/33**

(84) Designated Contracting States:
**AT DE FR GB SE**

(71) Applicant: **SOLARI UDINE S.P.A.**
**Via Gino Pieri, 29**
**I-33100 Udine(IT)**

(72) Inventor: **Sandretti, Enzo**
**Via Piemonte, 20**
**I-33010 Cavalicco-Tavagnacco (Udine)(IT)**
Inventor: **Bertossi, Bruno**
**Via Campo, 54**
**I-33013 Gemona del Friuli (Udine)(IT)**

(74) Representative: **Mariani, Giorgio, Dr. et al**
**INDUSTRIE PIRELLI S.p.A. Direzione Brevetti**
**Piazzale Cadorna, 5**
**I-20123 Milano(IT)**

(54) **Apparatus for distributing axial electric components.**

(57) The patent describes an apparatus for distributing axial electric components (31), which is intended to cut their leads (32) to a desired size and to convey them to a coining station.

When the apparatus is operating, the motion of said components (31) is carefully checked by means of supports (15) and guiding elements (12). In this way any risk of damage to the components and to the apparatus and/or any possible jamming of the latter are prevented.

EP 0 327 916 A2

Fig. 1

## APPARATUS FOR DISTRIBUTING AXIAL ELECTRIC COMPONENTS

The present invention concerns an apparatus for distributing axial electric components, namely components having a cylindrical body and leads in coaxial position. These apparatuses, utilized in systems for the automatic assembling of electric components on printed circuit boards, are fed with a plurality of components arranged parallel and connected to one another, which are wound up on a roll. In particular, the components taken up on the roll are made integral to one another by a pair of tapes to which are engaged the leads' ends.

Said apparatuses provide to cut to size the leads of the components, stripping them from the tapes, and to convey them, through pneumatic conduits, to coining pliers or to a coining station, from which the pliers take the coined components.

Apparatuses of the above indicated type are already known; one of them is described for example in U.S.Pat. 4 469 268. According to said patent, the components, still integral to the pair of tapes, are individually housed, leaning with their leads, in the cavities of a pair of coaxial saw-tooth wheels having an equal diameter and appropriately spaced.

By the intermittent rotation of the wheels, the components still fast with the tapes are deposited one by one into a movable channel - whose side nearest the pair of saw-tooth wheels is concave - which is obtained on the upper face of a movable cutter member slidable in the free space existing between the lower halves of the wheels.

While said movable cutter member slides in a direction perpendicular to the axis of rotation of the saw-tooth wheels and moves away therefrom, originating the motion of the channel it comprises, the ends of the concave side of said channel are compelled to slide at the level of two stationary cutting members to cut the leads at the surface of contact between the stationary cutting member and the movable cutter member, releasing the components from the tapes.

As the movable cutter member continues its progressive detachment from the saw-tooth wheels, the channel - which now contains a component free from other components and having its leads cut to size - closes a pneumatic circuit whose remaining parts are stationary, becoming itself a part thereof. In this way the component can be removed by a jet of compressed air. Subsequently, the movable cutter member and therefore the channel therein contained begin a back motion towards their start position, so that the pneumatic circuit is made again discontinuous and therefore opened.

A new cycle can now be started, in which the saw-tooth wheels - whose movements are obviously synchronized with those of the movable cutter member - situate a new component inside the channel.

The use of an apparatus of this kind may give rise to jammings, in consequence of which the components may be damaged. In fact, the leads of the component which are not supported during the cutting at the concave side of the channel obtained in the movable cutter member can risk to be improperly bent.

Further, owing to the presence of the concavity on one of its sides, the channel - at its ends connected to the fixed lengths of the pneumatic conduit - has minimum sections which are equal to the section of the latter whilst, at its central portion, has progressively increasing sections. Therefore, when the channel has closed the pneumatic circuit and when air under pressure has been supplied into it, the difference between the sections may ingenerate turbulent air flows inside the channel, so that the component may be subjected to impacts against the channel's walls, suffering a possible damage.

Also, the apparatus may jam up if the component, on account of the turbulent air motion, remains trapped in the channel convex portion and can no longer be conveyed in the pneumatic circuit. Moreover, the swarf originated when the leads are cut to size may remain adherent to the lateral surfaces of the movable cutter member at the channel, compromising the seal of the pneumatic circuit owing to the scratches caused on the coupling surfaces between the cutter member comprising the channel and the fixed parts of the pneumatic circuit.

The present invention aims to provide an apparatus for distributing axial electric components which - in operation - is able to check carefully the motion of said components, preventing any risk of damage both for them and for the apparatus as well as any risk of jamming for the latter.

Accordingly, the object of the present invention is an apparatus for distributing to a conduit axial electric components supplied by tapes which engage the ends of leads outcoming from the body of said components, said apparatus comprising :
- a fixed frame provided with stationary cutting blades,
- a movable cutting blade, moving in a stated direction, which, in association with the stationary cutting blades, cuts the leads of the components to a pre-determined length and disengages them from the tapes
- at least a pair of saw-tooth wheels rotating intermittently around a shaft perpendicular to the direction of motion of the movable cutting blade, said wheels being provided with cavities to encase individually the components still fast with the tapes and to position them in front of said movable cutting blade,

- a pneumatic channel to receive the component whose leads have been cut to size,
- a mechanism to carry out the intermittent rotation of the wheels, and means to move the movable cutting blade, and being characterized in that it further comprises :
- a support for the components during the cut to size of their leads and during their travel from the cutting station to the point of fall of the components into the channel, arranged in fixed position in the apparatus,
- a guiding element, accompanying the motion of the components when they leave the support to fall into the channel,
- a movable lid to open and close the channel.

In a preferred embodiment of an apparatus according to the invention, the support for the components is represen ted by the movable cutting blade, whose front part comprises lateral end portions protruding forward with respect to the central portion, said lateral end portions following the profile of the leads and said central portion following the profile of the component body.

Still in a preferred embodiment of an apparatus according to the invention, the guiding element accompanying the motion of the components, when they leave the support to fall into the channel, is a flat spring.

The present invention will be better understood from the following detailed description, given only by way of non-limiting example, and made with reference to the figures of the accompanying sheets of drawings, in which :

FIGURE 1 - is a side sectional view of a particular apparatus in accordance with the invention, with parts broken away;

FIGURE 2 - is a side view of the mechanism for the advancement of the saw-tooth wheels;

FIGURE 3 - is a plan view of some elements of the appartatus, with parts broken away;

FIGURE 4 - is a plan view of other elements of the apparatus, with parts broken away.

A particular embodiment of an apparatus for distributing axial electric components, for instance resistors, in accordance with the invention, will now be described.

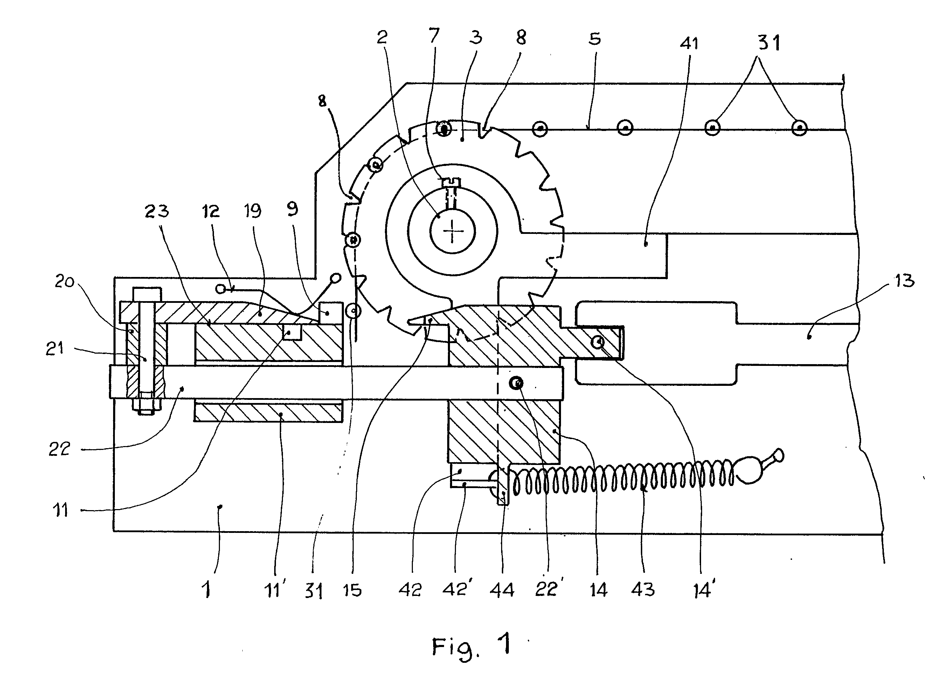

A stationary frame (1) (see FIGS. 1, 3 and 4) carries, assembled onto it, a telescopic shaft (2), on which is keyed a pair of saw-tooth wheels (3),(4) of equal diameter,and is mounted a pair of guides (5)-,(6) for components (31). Wheels (3),(4), by means of cavities obtained cn their profile, support compo-

nents (31) which reach the apparatus after having been paid off from a reel situated upstream guides (5),(6) and not illustrated in the figures; in said components the ends of leads (32), departing from body (34), are connected to a pair of tapes (33).

The extension of the telescopic shaft (2) can be adjusted by a screw (7) to vary the distance between the saw-tooth wheels (3),(4) to fit to the width of components (31) which are to be housed one by one, leaning with their leads (32), into cavities (8) of said wheels (3),(4).

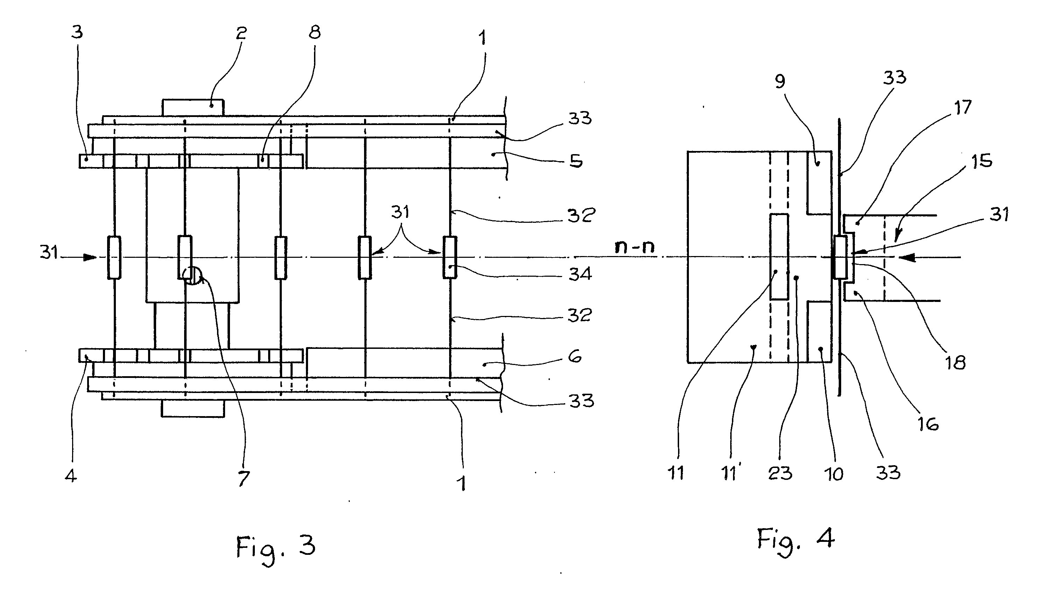

The distance between adjacent cavities (8) corresponds obviously tc the pitch of components (31) along tapes (33) or to a sub-multiple of said pitch. Downstream wheels (3),(4) and at opposite sides with respect to the medium plane n-n of the apparatus (whose path is visible in FIGS.3 and 4), there are stationary cutting blades (9),(10), and downstream them there is a pneumatic channel (11) having a constant cross section along its whole extension and obtained parallel to shaft (2), on surface (23) of a body (11') fastened to frame (1).

Channel (11), for a short portion situated astride plane n-n, is provided with a lid, having an alternative motion depending on the working cycle of the apparatus and controlled by means which will be illustrated in detail hereinafter. On the movable lid, constituted by a slidable plate (19), is situated a guiding element which, in the illustrated embodiment, is represented by a flat spring (12).

A piston (13), under the action of any conventional means not illustrated, carries out an alternative motion along plane n-n and below shaft (2). The piston carries, assembled to it by a pin (14'), a slide (14) which bears a movable cutting blade (15), also acting as a support and a guide for the components (see FIGS.1 and 4). In fact its front part has lateral end portions (16),(17), protruding forward with respect to its central portion (18), so that the former follows the profile of the leads and the latter that of the component body.

In this particular embodiment of the apparatus, the movable lid of the channel represented by plate (19) is rigidly secured to slid (14), following its motion. In further embodiments of the apparatus, not represented, said rigid connection between the movable lid and the slide can be lacking. In any case, however, it is indispensable to provide synchronization between their respective movements, as it will be apparent from the following description of the operation.

Plate (19) is connected - through a pivot (20) and a bolt (21) - to a stem (22) mounted on slide (14) by a pin (22'). Said plate (19) can slide with alternative motion on surface (23) of body (11'), originating the opening and the closure of channel (11).

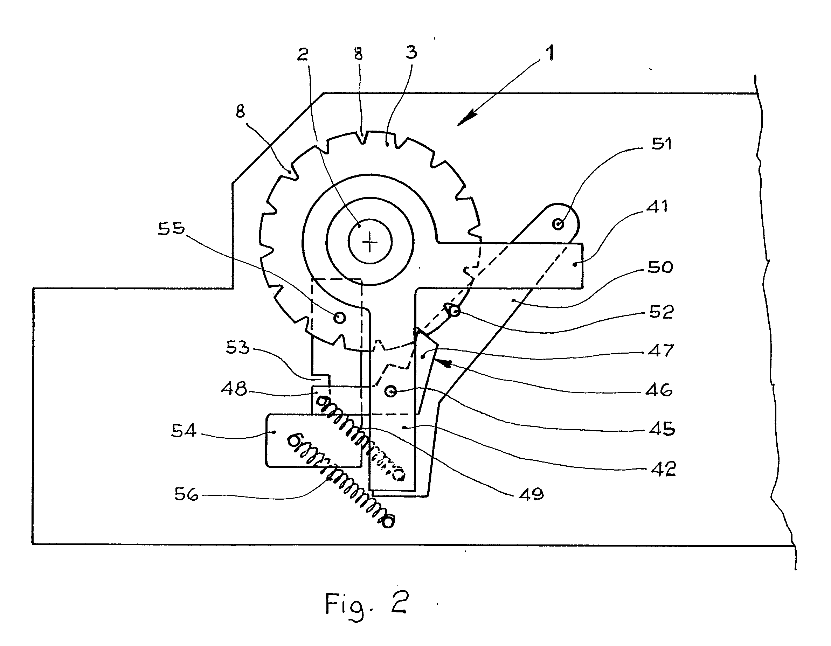

The apparatus according to the invention is also provided with a mechanism to advance the pairs of saw-tooth wheels (3),(4); said mechanism is represented in detail in FIG.2. It comprises a first lever (41), freely rotatable about shaft (2) and provided with an appendix (42). The latter (see again FIG.1) has in its lower end an extension (42'), connected by a first spring (43) to frame (1) and interfering with a protuberance (44) of slide (14).

Appendix (42) carries also a first journal (45) about which can rotate a jack (46); one end (47) of said jack engages with a cavity of the saw-tooth wheel (3), whilst the other end (48) is connected, through a second spring (49), to a second lever (50). Further, end (48) of jack (46) is situated in a recess (53) of a third lever (54).

The second lever (50) is pivoted to frame (1) by means of a second journal (51) and, by means of a third journal (52), it can stop the rotation of the saw-tooth wheel (3). The third lever (54) is pivoted to frame (1) by means of a fourth journal (55) and is moreover connected to frame (1) by a third spring (56), with the possibility of rotating about the fourth journal (55), overcoming the resistance of said spring (56).

The task of the above described mechanism is that of rotating by jerks of pre-established entity, owing to the movement of piston (13), the saw-tooth wheels (3), (4), supporting the components.

The working cycle of the apparatus will now be described with reference to FIGS.1 and 3. The forward motion of piston (13) causes the advancement of slide (14), lid (19), channel (11) and movable cutting blade (15), the latter coming to be in front of a component (31), brought to this point by the motion of the saw-tooth wheels (3), (4), which will be described herebelow. This component is still engaged to the tapes through leads (32), just detached from a cavity (8) of the saw-tooth wheels (3),(4).

Immediately afterwards, leads (32) are compelled to pass between the movable cutting blade (15) and the pair of stationary cutting blades (9),- (10) (see FIG.4) and are therefore cut to the pre-established size, releasing component (31) from any engagement with tapes (33). Then component (31) is pushed by the movable cutting blade (15), which causes it to slide on surface (23) of body (11') until it falls into channel (11), which in this working phase is obviously opened.

As already said, the profile of the front part of the movable cutting blade (15) follows that of leads (32) and of body (34) of component (31) which therefore -both during the cutting of the leads and during its sliding on surface (23) - is perfectly supported and guided and cannot suffer any prejudice.

Also the fall of the component into the channel cannot be disturbed by accidental factors, because during its fall the component is guided by the flat spring (12) which acts on its body (34), checking its movements and preventing also in this case any possible damage.

The backward motion of piston (13) - through the plate (19) connected to it - causes the closure of channel (11). Therefore it is possible to use here, with conventional means not described, a jet of compressed air to move away component (31) without any risk of damage for the same or of jamming for the apparatus. In fact the channel, having at any point a constant cross section, equal to the cross section of the remaining part of a pneumatic conduit, not illustrated in the figures, of which it makes part, does not involve the generation of turbulence in the flow of the air jet.

The operation of the mechanism for advancing the saw-tooth wheels (3),(4) will now be described with reference to FIGS.1 and 2.

During the forward motion of piston (13), slide (14) pushes with its protuberance (44) extension (42') of the first lever (42), rotating it clockwise and loading the first spring (43). This causes the rotation of jack (46), which is pivoted on the first lever (42) through the first journal (45). It rotates clockwise and enters a cavity (8) of the saw-tooth wheel (3) following to that it had entered before, thus loading also the second spring (49), which connects it to the second lever (50).

In this phase a rotation of the saw-tooth wheel (3) is prevented by the third journal (52) of the second lever (50), which is housed in one of its cavities (8). In this way piston (13), in its forward stroke, has armed jack (46); subsequently, during the backward motion of piston (13), the first lever (42) takes again its start position, rotating counterclockwise under the action of the first spring (43). Also jack (46) is dragged into rotation, by virtue of the first journal (45), which connects it to the first lever (42), and of the second spring (49) which had been previously loaded.

During this movement, jack (46) rotates by one counterclockwise step the saw-tooth wheel (3), which overcomes the blocking action of the second journal (52) of the second lever (50), since the latter is free to rotate counterclockwise with respect to its journal (51), connecting it to frame(1). An advancement of wheel (3) by more than one step is prevented by jack (46), whose end (48) is fastened inside cavity (53) of the third lever (54).

A complete working cycle of the mechanism is so performed so that, during the subsequent advancement of piston (13), the movable cutting blade (15) will face a new component and shall be able to cut the leads to size and to insert said component in the channel in accordance with the above indicated modalities.

It is clear that an apparatus as that described above can operate individually or in combination with others of the same kind.

From the above it is evident that the apparatus forming the object of the invention operates without any risk of jamming and/or of damage for the components. In fact, a component can never interfere prejudicially with elements in motion, as instead it may happen in the apparatuses of the prior art. This is due to the fact that the component, from the moment in which the leads are cut,to the time it falls into the pneumatic channel, is always supported by the movable cutting blade which follows its profile. In this way sudden and dangerous movements, which may cause for instance a bending of the leads, are avoided.

Further, the presence of a flat spring, guiding the fall of the component, allows in any case the correct insertion of the latter in the channel. Moreover, the closure of said channel by means of a movable lid, once the component has fallen therein, takes place without any contact between the component and the lid.

Consequently, it is evident that any interference between the component and the mechanical element in motion, with damade for the former and jamming for the latter, is quite impossible. On the contrary, in the conventional apparatuses, the movement of a whole section of the channel containing a component in its inside could easily give rise to drawbacks of this type.

Although the invention has been described with reference to a preferred embodiment, it is not restricted to the latter, but includes in its scope any other variation and/or modification deducible from the above indicated inventive idea.

## Claims

1. An apparatus for distributing to a conduit axial electric components (31) supplied by tapes (5),(6) which engage the ends of leads (32) outcoming from the body (34) of said components (31), said apparatus comprising :
- a fixed frame (1) provided with stationary cutting blades (9),(10),
- a movable cutting blade (15), moving in a stated direction, which, in association with the stationary cutting blades (9),(10), cuts the leads (32) of the components (31) to a pre-determined length and disengages them from the tapes (5),(6),
- at least a pair of saw-tooth wheels (3),(4) rotating intermittently around a shaft perpendicular to the direction of motion of the movable cutting blade (15), said wheels (3),(4) being provided with cavities (8) to encase individually the components (31) still fast with the tapes (5),(6) and to position them in front of said movable cutting blade (15),

- a pneumatic channel (11) to receive the component (31) whose leads (32) have been cut to size,
- a mechanism to carry out the intermittent rotation of the wheels (3),(4), and means to move the movable cutting blade (15),
and being characterized in that it further comprises:
- a support (23) for components (31) during the cut to size of their leads (32) and during their travel from the cutting station to the point of fall of said components (31) into channel (11), arranged in fixed position in the apparatus,
- a guiding element (12), accompanying the motion of the components when they leave support (23) to fall into channel (11),
- a movable lid (19) to open and close channel (11).

2. An apparatus as in CLAIM 1, characterized in that support (23) for components (31) is represented by the movable cutting blade (15), whose front part has lateral end portions (16) protruding forward with reepect to the central portion (18), said lateral end portions (16) following the profile of leads (32) and said central portion (18) following the profile of the component's body.

3. An apparatus as in CLAIM 1, characterized in that the guiding element accompanying the motion of the components, when they leave support (23) to fall into the channel, is a flat spring (12).

4. An apparatus as in CLAIM 1, characterized in that the movable lid (19) of channel (11) is represented by a movable plate rigidly secured to the movable cutting blade (15), following its motion.

Fig. 1

EP 0 327 916 A2

EP 0 327 916 A2

Fig. 2

Fig. 4

Fig. 3

n-n